# EUROPEAN PATENT APPLICATION

(11) **EP 2 400 823 A1**
(43) Date of publication of application: **28.12.2011**
(21) Application number: 11157956.1
(22) Date of filing: 11.03.2011
(51) Int. Cl.: H05K 1/18, H05K 3/34

(54) **Circuit board, circuit board assembly, and semiconductor device**

(30) Priority: 14.06.2010 JP 2010135116
(71) Applicant: FUJITSU LIMITED, Kawasaki-shi, Kanagawa 211-8588 (JP)
(72) Inventor: Kobayashi, Hiroshi, Kawasaki-shi Kanagawa 211-8588 (JP); Okada, Toru, Kawasaki-shi Kanagawa 211-8588 (JP); Emoto, Satoshi, Kawasaki-shi Kanagawa 211-8588 (JP); Kitajima, Masayuki, Kawasaki-shi Kanagawa 211-8588 (JP)
(74) Representative: Stebbing, Timothy Charles

(57) **Abstract**

A disclosed circuit board includes a substrate including wirings; plural electrode pads that are formed on a surface of the substrate and that are to be bonded to external connection terminals of the electronic parts; and grooves formed around the respective electrode pads on the surface of the substrate. Further, the grooves form an air space by which lower parts of the electrode pads on the substrate are separated from surrounding elements.

## Description

### TECHNICAL FIELD

The present invention relates to a circuit board on which electronic parts are to be mounted, a circuit board assembly, and a semiconductor device.

### BACKGROUND ART

Electronic apparatuses generally include a circuit board (which may also be called "wiring substrate" and the like) on which electronic parts such as a semiconductor device are mounted. Recently, the size of such an electronic apparatus has been made smaller. Accordingly, electronic parts are required to be mounted in higher density on the circuit board, and the size of the circuit board has been made smaller. As a result, the size of the mounting structure for mounting electronic parts on the circuit board has also been made smaller.

As a bonding member for mounting a semiconductor device on a circuit board, a solder bump is usually used. By using the solder bump, solder bonding may be achieved that provides not only electric connection but also mechanical fixing between the semiconductor device and the circuit board. As described above, the mounting structure has been becoming smaller. Accordingly, the solder bump has been becoming smaller and the solder bonding part has been becoming smaller. As a result, due to thermal stress or external pressure, the solder bump bonding section is more likely to be deformed and damaged, which may easily lead to disconnection between the semiconductor device and the circuit board.

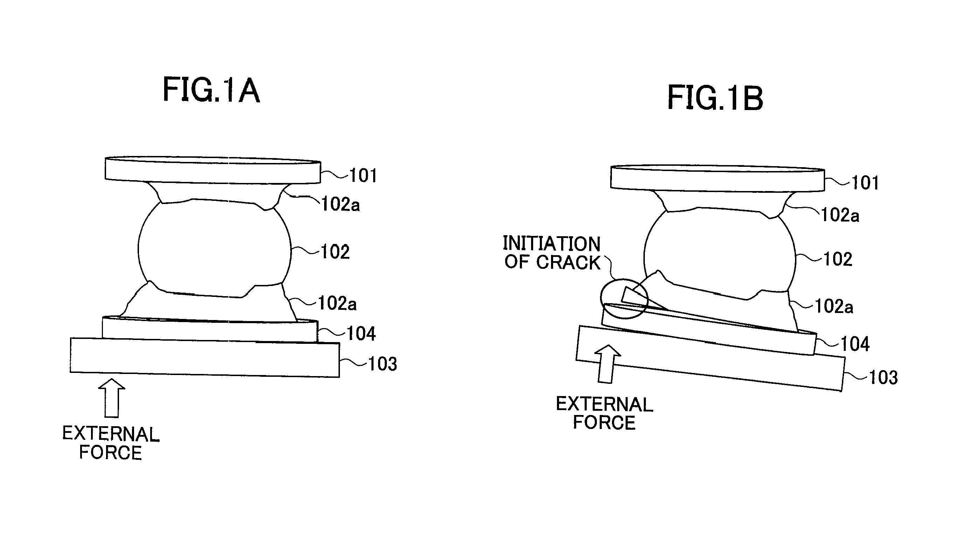

Next, the deformation of the solder bump is described when an external force is applied to the solder bump formed in the mounting structure with reference to FIGS. 1A and 1B. FIG. 1A illustrates a mounting structure in which an electrode pad 101 of a semiconductor device is connected to a connection pad 104 of a circuit board 103 by means of a solder bump 102. The solder bump 102 is formed by being melted and then solidified in a solder reflow process, so that a solder bonding parts 102a are formed where one is adhered to each of the electrode pad 101 and the connection pad 104. FIG. 1A illustrates where no external force is being applied to the solder bump 102, and therefore, the solder bump 102 is not being deformed.

However, when an external force is applied to the position illustrated in FIG. 1A, the circuit board 103 is deformed in a manner such that the part to which the external force is applied is pushed up, and at the same time, the solder bump 102 is also deformed as illustrated in FIG. 1B. In this case, as illustrated in FIG. 1B, the position to which the external force is applied is shifted from the center of the solder bump 102. Therefore, a stress is concentrated to (concentratedly generated at) the end potion of the solder bonding part 102a on the side closer to the position to which the external force is applied. When the external force is removed, the stress is removed and the deformation of the solder bump 102 disappears. As the result, the shape is restored to its original shape as illustrated in FIG. 1A.

When such an external force is repeatedly applied to the circuit board 103, the stress is repeatedly concentrated between the solder bonding part 102a and the connection pad 104. As a result, the end of the solder bonding part 102a may be peeled off from the connection pad 104. When the peeling propagates further inside, the electric connection between the solder bonding part 102a and the connection pad 104 may be cut off, which leads to disconnection.

In response to the problem, an underfill material is supplied between the mounted semiconductor device and the circuit board. Namely, an underfill material made of epoxy resin and the like is applied to the surroundings of the solder bonding part 102a so as to reinforce the solder bonding part 102a from the surroundings, and the bottom surface of the semiconductor device is mechanically fixed to the surface of the circuit board by means of the underfill material. By doing in this way, compressive strength and long-term reliability are improved.

Recently, among other things, sizes of electronic apparatuses such as a cell phone and a portable computer like a laptop computer have been becoming smaller and the functions of the electronic apparatuses have become more sophisticated. As a result, a force applied to a chassis of the electronic apparatus is more likely to be further applied to the circuit board and mounting structure part inside the electronic apparatus. Due to this, in order to further improve the compressive strength and the long-term reliability of the solder bonding part, an underfill material having higher bonding strength and higher Young's modulus has started being used. However, when such an underfill material having higher bonding strength is in use, it may become difficult to detach the semiconductor device from the circuit board, the semiconductor device having been fixed to the circuit board with the underfill material.

For example, when a function of the semiconductor device fails after the semiconductor device is mounted on the circuit board, it may not be possible to remove only the defective semiconductor from the circuit board for replacement. In that case, it becomes necessary to replace the expensive entire circuit board, which may increase spoilage cost (defective work cost) of the circuit board. Further, the semiconductor thought to be defective may not be separately tested. Therefore, it may not be possible to analyze and specify the cause of the defect, which may cause an increase of the failure rate.

To solve the problem, for example, Japanese Laid-Open Patent Application No. 3-136334 (Patent Document 1) discloses an external electrode structure on a semiconductor substrate, in which a part of the insulation film right below the bump electrode is thinner than any other part so as to form a concave part, and a groove is formed on the insulation film in a manner such that the groove surrounds concave part. By having this structure, it is proposed that the distortion of the insulation film around the circumference of the bump electrode bonding section is alleviated.

In the mounting structure disclosed in Patent Document 1, the stress applied to the part of the insulation film around the circumference of the bump electrode bonding section is alleviated so as to prevent the insulation film from being damaged. This mounting structure, however, is not for alleviating the stress generated at the bump electrode bonding section. Therefore, it may still be necessary to use such an underfill material to fix the semiconductor device to the circuit board to ensure the reliability of the bump electrode bonding section.

Therefore, it may be desired to provide a mounting structure improving the anti-compressive characteristic and the long-term reliability of the bonding part of the semiconductor device without using such an underfill material and allowing easy removal of the mounted semiconductor device from the circuit board.

### SUMMARY OF THE INVENTION

According to an aspect of the present invention, there is provided a circuit board on which electronic parts are to be mounted. The circuit board includes a substrate including wirings; plural electrode pads that are formed on a surface of the substrate and that are to be bonded to external connection terminals of the electronic parts; and grooves formed around the respective electrode pads on the surface of the substrate. Further, the grooves form an air space by which lower parts of the electrode pads on the substrate are separated from surrounding elements.

According to another aspect of the present invention, a circuit board assembly includes the above circuit board; and a semiconductor device having external connection terminals, the semiconductor device being mounted by bonding between the electrode pads and the external connection terminals, in which an air space is formed in a region that is between the semiconductor device and the circuit board and that is other than the external connection terminals.

According to another aspect of the present invention, a semiconductor device includes a semiconductor substrate; an interposer substrate formed on the semiconductor substrate; plural electrodes that are formed on a surface of the interposer substrate and that are to be bonded to external connection terminals of a circuit board; and grooves formed around the respective electrodes on the surface of the interposer substrate. Further, the grooves form an air space by which lower parts of the electrodes on the interposer substrate are separated from surrounding elements.

Due to the grooves in the configurations described above, the part right below the electrode pad of the circuit board is separated from surrounding elements (parts). Further, due to the grooves, the stress generated near the bonding part of the electrode may be alleviated, the stress being generated due to the deformation of the separated part. Because of this feature, it may become possible to control the occurrence of peeling-off of the bonding part, thereby improving the anti-compressive characteristic and the long-term reliability of the bonding part of the electronic parts. Therefore, it becomes no longer necessary to use the underfill material to bond the electronic parts to the circuit board and it may become possible to easily remove the electronic parts from a circuit board, the electronic parts being mounted on the circuit board.

### BRIEF DESCRIPTION OF DRAWINGS

FIGS. 1A and 1B are drawings illustrating the deformation of the solder bump when an external force is applied to a solder bump bonding section;
FIG. 2 is a cross-sectional view of a circuit board assembly according to an embodiment of the present invention;
FIG. 3 is a perspective view illustrating a semiconductor device and a part of the circuit board on which the semiconductor device is to be mounted;
FIGS. 4A and 4B are cross-sectional views illustrating the deformation of the circuit board and an interposer substrate when the circuit board is deformed;
FIG. 5 is a table illustrating simulation results of stresses generated at the solder bump for investigating an effect of formed grooves;
FIG. 6 is a perspective view illustrating a circuit board having circular electrode pads;
FIG. 7 is a perspective view illustrating a circuit board having annular grooves formed so as to surround the respective circular electrode pads;
FIG. 8 is a cross-sectional view of a circuit board assembly formed by mounting the semiconductor device on the circuit board having the annular grooves as illustrated in FIG. 7;
FIG. 9 is a top view of a circuit board on which the annular grooves are formed for all the electrode pads;
FIG. 10 is a top view illustrating a circuit board on which a lattice-shaped groove is formed;
FIG. 11 is a cross-sectional view of a circuit board assembly formed by mounting the semiconductor device on the circuit board as illustrated in FIG. 10;
FIG. 12 is a top view of a circuit board on which the annular grooves are formed for only the electrode pads to be bonded to the solder bumps disposed in the vicinity of the four corners of the semiconductor device;
FIG. 13 is a cross-sectional view of a circuit board assembly formed by mounting the semiconductor device on the circuit board as illustrated in FIG. 12;
FIG. 14 is a top view of a circuit board on which the annular grooves are formed for only the electrode pads to be bonded to the solder bumps disposed at the four corners of the semiconductor device; and
FIG. 15 is a cross-sectional view of a circuit board assembly formed by mounting the semiconductor device on the circuit board as illustrated in FIG. 14.

### BEST MODE FOR CARRYING OUT THE INVENTION

Next, embodiments of the present invention are described with reference to the accompanying drawings.

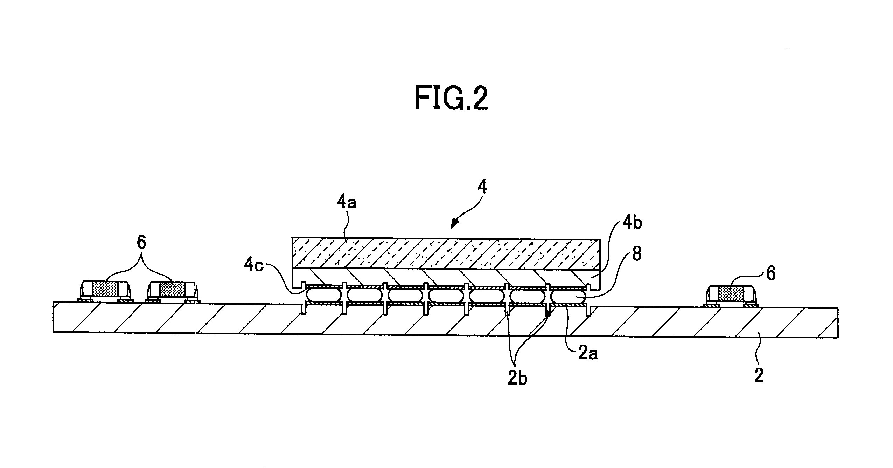

FIG. 2 is a cross-sectional view of a circuit board assembly according to one embodiment of the present invention. As illustrated in FIG. 2, the circuit board assembly includes a circuit board 2, a semiconductor device 4, and a passive device 6 such as a resistor, a capacitor and the like, so that the semiconductor device 4 and the passive device 6 are mounted on the circuit board 2. The circuit board 2 includes wirings on the surface of and inside of the circuit board 2. The semiconductor device 4 includes electrodes 4c. The electrodes 4c are bonded to respective electrode pads 2a of the circuit board 2 by way of solder bumps 8 which serve as bonding members.

The circuit board 2 is, for example, a multilayer board formed by using an organic board material such as glass epoxy. On a surface of the circuit board 2, the electrode pads 2a to be used for mounting the semiconductor device 4 are arranged. Further, there is a groove 2b formed around each of the electrode pads 2a. As a result, lower parts of the electrode pads 2a of the circuit board 2 are separated from each other by the grooves 2b. In other words, due to the grooves 2b, air space is formed around the lower parts of the electrode pads 2a of the circuit board 2. Due to the formed air space, the electrode pads 2a are (physically) separated from surrounding elements (including adjacent electrodes, parts, substances and the like), and can be slightly but separately deformed.

As a method of forming the grooves 2b on the circuit board 2, there is a method in which a resist is formed on a part where the grooves 2b are to be formed in a process of forming the circuit board 2 first and then the resist is removed to form the grooves 2b. Otherwise, there is another method of forming the grooves 2b in which after the circuit board 2 is formed, the surface of the circuit board 2 is cut using a dicing saw. Otherwise, there is still another method of forming the grooves 2b in which after the circuit board 2 is formed, the surface of the circuit board 2 is cut by using a laser.

As schematically illustrated in FIG. 2, the semiconductor device 4 further includes a semiconductor substrate 4a and an interposer substrate 4b. The semiconductor substrate 4a is formed of silicon or the like. The interposer substrate 4b is formed on the semiconductor substrate 4a. As external terminals of the semiconductor device 4, the solder bumps 8 are formed (provided) on respective electrodes 4c of the interposer substrate 4b. The interposer substrate 4b is formed of a substrate material such as polyimide resin, glass epoxy, or the like. Typically, the interposer substrate 4b is more flexible than the semiconductor substrate 4a.

On the surface of the interposer substrate 4b, the electrodes 4c to be bonded to the respective solder bumps 8 are arranged, the solder bumps 8 serving as the external terminals. Further, grooves 4d are formed around the respective electrodes 4c. As a result, lower parts of the electrodes 4c of the interposer substrate 4b are separated from each other by the grooves 4d. In other words, due to the grooves 4d, air space is formed around the lower parts of the electrodes 4c of the circuit board 2. Due to the formed air space, the electrodes 4c are (physically) separated from surrounding elements and can be slightly but separately deformed.

As a method of forming the grooves 4d on the interposer substrate 4b, there is a method in which a resist is formed on a part where the grooves 4d are to be formed in a process of forming the interposer substrate 4b, and then the resist is removed to form the grooves 4d. Otherwise, there is another method of forming the grooves 4d in which after the interposer substrate 4b is formed, the surface of the interposer substrate 4b is cut using a dicing saw. Otherwise, there is still another method of forming the grooves 4d in which after the interposer substrate 4b is formed, the surface of the interposer substrate 4b is cut by using a laser.

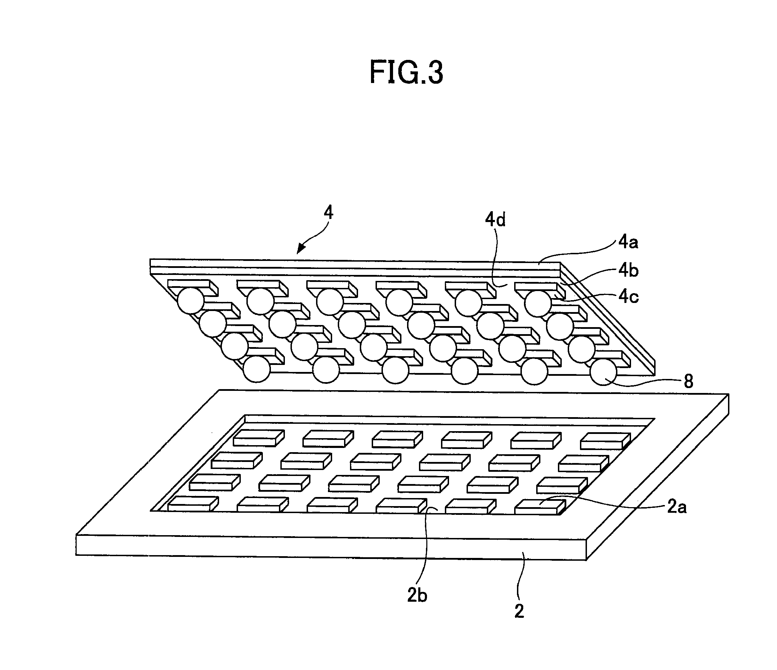

FIG. 3 is a perspective view illustrating a semiconductor device 4 and a part of the circuit board 2 on which the semiconductor device 4 is to be mounted. The width of the grooves 2b on the circuit board 2 and the width of the grooves 4d on the interposer substrate 4b of the semiconductor device 4 in FIG. 3 are greater than the widths of the grooves 2b and the grooves 4d, respectively, which are illustrated in FIG. 2. However, it should be noted that the widths of the groove 2b and the groove 4d may be adequately changed (determined) based on, for example, the interval between the arranged grooves 2b and 4d. The purpose of forming the grooves 2b on the circuit board 2 is that the lower part of the electrode pads 2a of the circuit board 2 are separated from each other (surrounding elements) so as to be more easily deformed. The width of the grooves 2b can be arbitrarily determined. In the same manner, the purpose of forming the grooves 4d on the interposer substrate 4b is that the lower part of the electrodes 4c of the interposer substrate 4b are separated from each other (surrounding elements) so as to be more easily deformed. The width of the grooves 4d can be arbitrarily determined.

In the configuration of FIG. 3, the electrode pads 2a of the circuit board 2 have a rectangular shape and are arranged in a matrix manner. Further, the grooves 2b are formed as straight grooves so as to extend in a (an orthogonal) lattice manner between the electrode pads 2a. As a whole, those straight grooves 2b can be regarded as concave parts concave from the surface of the circuit board 2, and the electrode pads 2a can be regarded as parts protruding from the bottom surface of the concave parts.

Further, in the configuration of FIG. 3, the electrode pad 2a is much thinner than the depth of the grooves 2b. Therefore, the (top) surfaces of the parts separated from each other by the grooves 2b are illustrated as the electrode pads 2a. From the other point of view, the air space formed as the grooves 2b can be regarded as a concave part(s) formed on the circuit board 2, and the lower part of the electrode pads 2a can be regarded as protruding from the bottom surface of the concave part(s). This view may also be applied to the semiconductor device 4. Namely, the air space formed as the grooves 4d can be regarded as a concave part(s) formed on the interposer substrate 4b, and the lower part of the electrodes 4c can be regarded as parts protruding from the bottom surface of the concave part(s). However, in the configuration (example) of FIG. 3, the rim part of the interposer substrate 4b is removed (cut) to the same depth as the depth of the grooves 4d. As a result, FIG. 3 illustrates as if the bottom surface of the concave part(s) were the surface of the interposer substrate 4b and the lower parts of the electrodes 4c were protruding from the surface of the interposer substrate 4b.

As described above, by forming the grooves 2b and separating the lower parts of the electrode pads 2a of the circuit board 2 from surrounding elements (each other) so as to be more easily deformed, it may become possible to control (reduce) the concentration of stress (stress concentration) on the bonding parts of the solder bumps 8 when an external force is applied to the circuit board 2 so as to deform the circuit board 2, the stress being generated due to the deformation of the circuit board 2. Further, by forming the grooves 4d and separating the lower parts of the electrodes 4c of the interposer substrate 4b from surrounding elements (each other) so as to be more easily deformed, it may become possible to control (reduce) the stress concentration on the bonding parts of the solder bumps 8 when an external force is applied to the circuit board 2 so as to deform the circuit board 2, the stress being generated due to the deformation of the circuit board 2.

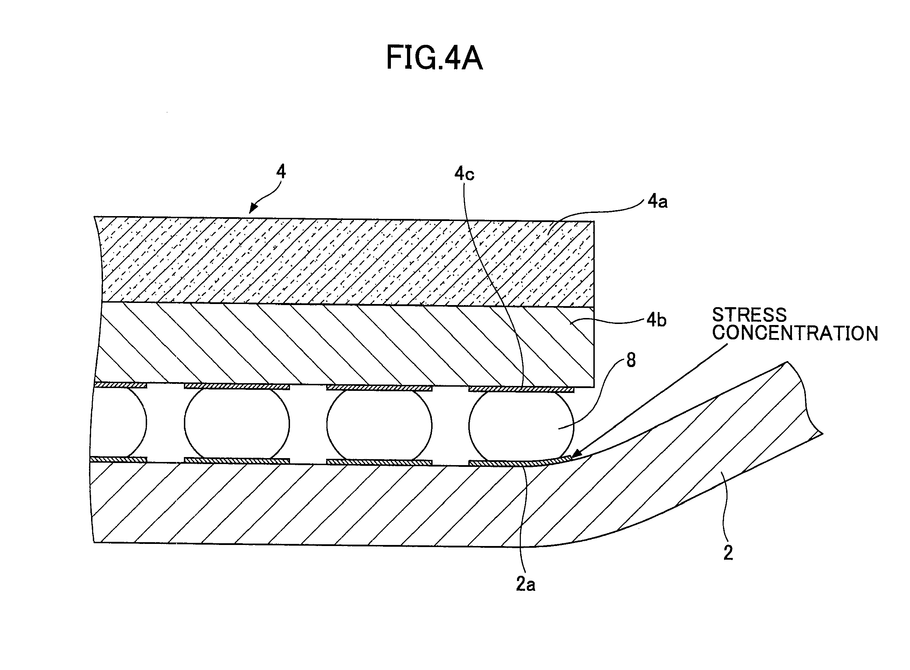

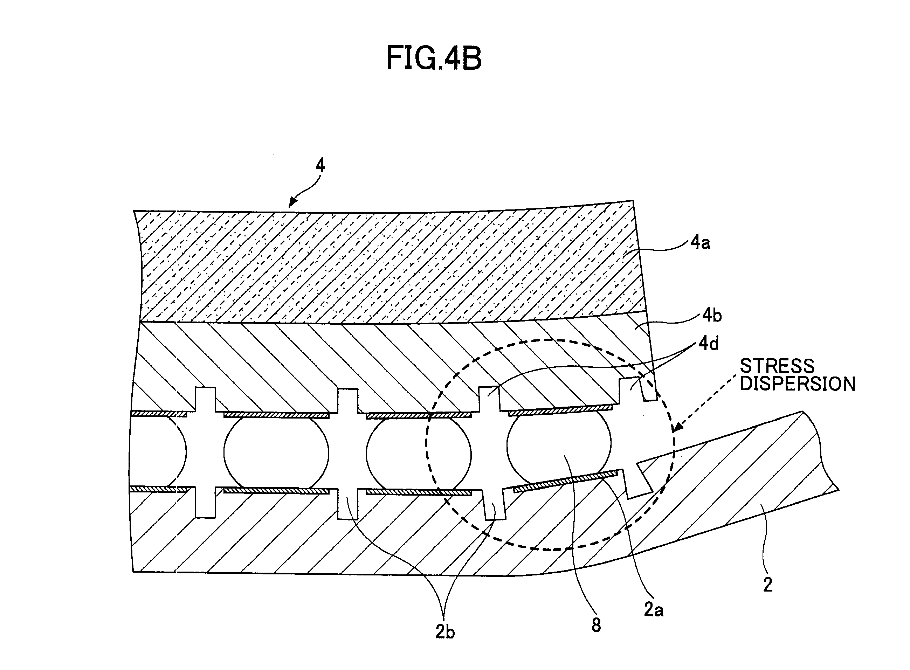

FIGS. 4A and 4B are enlarged cross-sectional views illustrating the deformation of the circuit board 2 and the interposer substrate 4b when the circuit board 2 is deformed. More specifically, FIG. 4A illustrates the deformation of the circuit board 2 when neither grooves 2b nor the grooves 4d have been formed. On the other hand, FIG. 4B illustrates the deformation of the circuit board 2 when the grooves 2b and the grooves 4d have already been formed. In the part corresponding to a part where the semiconductor device 4 is mounted, the deformation of the circuit board 2 is controlled because the semiconductor substrate 4a of the semiconductor device 4 is formed of silicon or the like and acts as the reinforcing member against the deformation. Because of this feature, the circuit board 2 is more likely to be deformed locally (mainly) at a region between the part where the semiconductor device 4 is not mounted and the part where the semiconductor device 4 is mounted. As a result, as schematically illustrated in FIG. 4A, the stress is more likely to be concentrated on the bonding part of the solder bump 8 disposed at the circumferential part of the semiconductor device 4 (i.e., the solder bump 8 disposed at the right end in FIGS. 4A and 4B). When the stress is repeatedly concentrated in this way, a crack may be initiated at the bonding part of the solder bump 8 and the bonding may be broken.

However, according to this embodiment of the present invention, when the grooves 2b are formed on the circuit board 2 and the grooves 4d are formed on the interposer substrate 4b of the semiconductor device 4, the region between the part where the semiconductor device 4 is not mounted and the part where the semiconductor device 4 is mounted is likely to be deformed more gradually (gently), and the stress generated on the solder bumps 8 in this region may be dispersed. Namely, the stress at the bonding part of the solder bumps 8 disposed at the circumferential part of the semiconductor device 4 (e.g., the solder bump 8 disposed at the right end in FIG. 4B) may be alleviated, and the stress concentration may be accordingly alleviated. Due to this alleviation of the stress, it may become possible to prevent a crack from being initiated at the bonding part of the solder bumps 8 disposed at the circumferential part of the semiconductor device 4 (e.g., the solder bump 8 disposed at the right end in FIG. 4B). As a result, better bonding reliability of the solder bumps 8 may be obtained. As described above, according to this embodiment of the present invention, it may become possible to improve anti-compressive capability and long-term reliability of the bonding parts of the solder bumps without using an underfill material or the like, and an effect may be obtained so that the semiconductor device 4 once mounted can be (smoothly) detached (removed) from the circuit board 2. Further, as described above, according to this embodiment of the present invention, the underfill material is not supplied between the semiconductor device 4 and the circuit board 2. Due to this feature, in the circuit board assembly according to this embodiment, air space is present (formed) in the region that is between the semiconductor device 4 and the circuit board 2 and that is other than the solder bumps 8.

In the above description of this embodiment, a case is described where, by forming the grooves 2b on the circuit board 2 and forming the grooves 4d on the interposer substrate 4b of the semiconductor device 4, the stress generated on the bonding parts may be alleviated. However, the present invention is not limited to this configuration. Namely, it is not always necessary to form both the grooves 2b on the circuit board 2 and the grooves 4d on the interposer substrate 4b of the semiconductor device 4. When at least one of the groove(s) 2b and the groove(s) 4d is formed, the above-described effects may also be obtained.

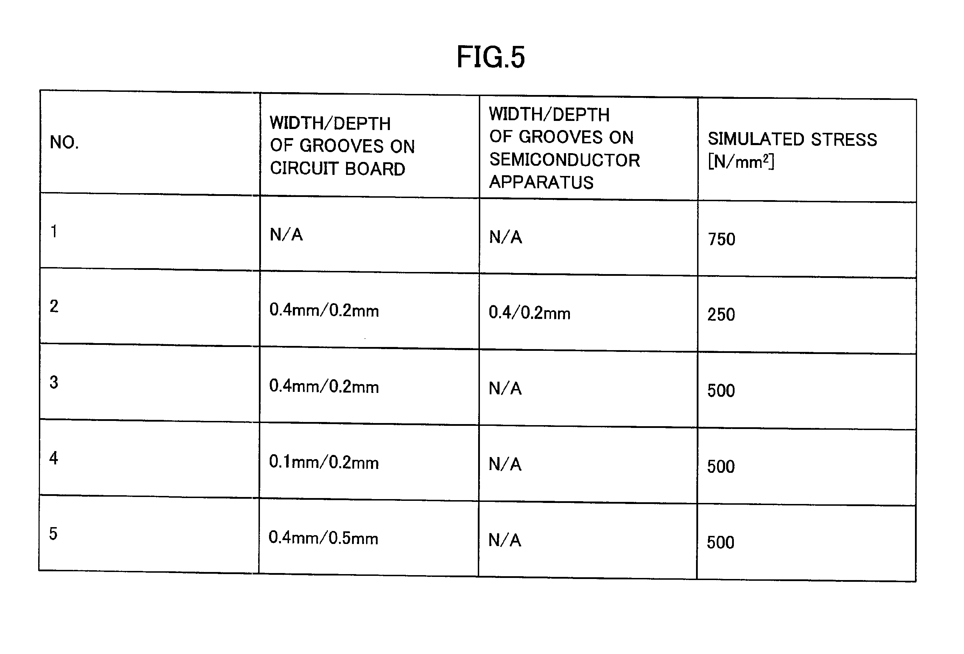

FIG. 5 is a table illustrating simulation results of stresses generated at the solder bumps 8 for investigating an effect of forming the grooves. In the simulation, it is assumed that the size of the semiconductor device 4 is 27 mm by 27 mm; the circuit board 2 is formed of glass epoxy; the diameter of the solder bumps 8 is 0.6 mm; and the distance between the adjacent solder bumps 8 is 1 mm. Under the above conditions, the semiconductor device 4 is mounted on the circuit board 2 and the stress to be generated on the solder bumps 8 is simulated (obtained). Further, typically, it is thought that the maximum stress is generated on the solder bumps 8 disposed at the four corners of the semiconductor device 4. Therefore, the stress to be generated on the solder bumps disposed at the four corners of the semiconductor device 4 is obtained. Further, it is assumed that the electrode pads 2a of the circuit board 2 have a circular shape and that annular grooves 2b are formed around the respective electrode pads 2a. In this simulation model, it is known that if the stress generated on the solder bumps 8 is equal to or less than 500 N/m², the structure has sufficient connection reliability.

In FIG. 5, row No. 1 corresponds to the simulation result when no grooves are formed on the circuit board 2 and the semiconductor device 4 (i.e., a case of a conventional mounting structure is simulated). In this case, according to the simulation result, the stress to be generated to the solder bumps 8 is 750 N/m². Further, row No. 2 corresponds to the simulation result when the width of the grooves formed on the circuit board 2 is 0.4 mm and the depth of the grooves is 0.2 mm, and the width of the grooves formed on semiconductor device 4 is 0.4 mm and the depth of the grooves is 0.2 mm. In this case, according to the simulation result, the stress to be generated on the solder bumps 8 is 250 N/m² which is much less than 500 N/m².

Further, in FIG. 5, row No. 3 corresponds to the simulation result in a case where grooves are formed only on the circuit board 2, and when the width of the grooves formed on the circuit board 2 is 0.4 mm and the depth of the grooves is 0.2 mm. In this case, according to the simulation result, the stress to be generated on the solder bumps 8 is 500 N/m². This result explains that even when the grooves are formed only on the circuit board 2 and no grooves are formed on the semiconductor device 4, sufficient connection reliability may also be obtained.

Further, in FIG. 5, row No. 4 corresponds to the simulation result in a case where grooves are formed only on the circuit board 2 and when the width of the grooves formed on the circuit board 2 is 0.1 mm and the depth of the grooves is 0.2 mm. In this case, according to the simulation result, the stress to be generated on the solder bumps 8 is 500 N/m². The conditions in simulation No. 4 are the same as the conditions in simulation No. 3 except that the width of the grooves is reduced to 0.1 mm. This result explains that even when the width of the grooves is reduced to 0.1 mm in simulation No. 4, the same stress to be generated on the solder bumps 8 is obtained as the stress when the width of the grooves is 0.4 mm in simulation No. 3. Therefore, it is understood that the effect of reducing the stress does not much depend on the change of the width of the grooves.

Further, in FIG. 5, row No. 5 corresponds to the simulation result in a case where grooves are formed only on the circuit board 2, and when the width of the grooves formed on the circuit board 2 is 0.4 mm and the depth of the grooves is increased to 0.5 mm. In this case, according to the simulation result, the stress to be generated on the solder bumps 8 is 500 N/m². The conditions in simulation No. 5 are the same as the conditions in simulation No. 3 except that the depth of the grooves is increased to 0.5 mm. This result explains that even when the depth of the grooves is increased to 0.5 mm in the simulation No.4, the same stress to be generated on the solder bumps 8 is obtained as the stress when the depth of the grooves is 0.2 mm in the simulation No. 3. Therefore, it is understood that the effect of reducing the stress does not much depend on the change of the depth of the grooves. Otherwise, it may be thought that grooves having the depth of 0.2 mm provide sufficient deformation of the circuit board 2 and that even when the depth is greater than 0.2 mm, the effect may not be improved.

Next, modification in the shape of the grooves in the above-described embodiment is described by describing examples of the grooves. 2b formed on the circuit board 2.

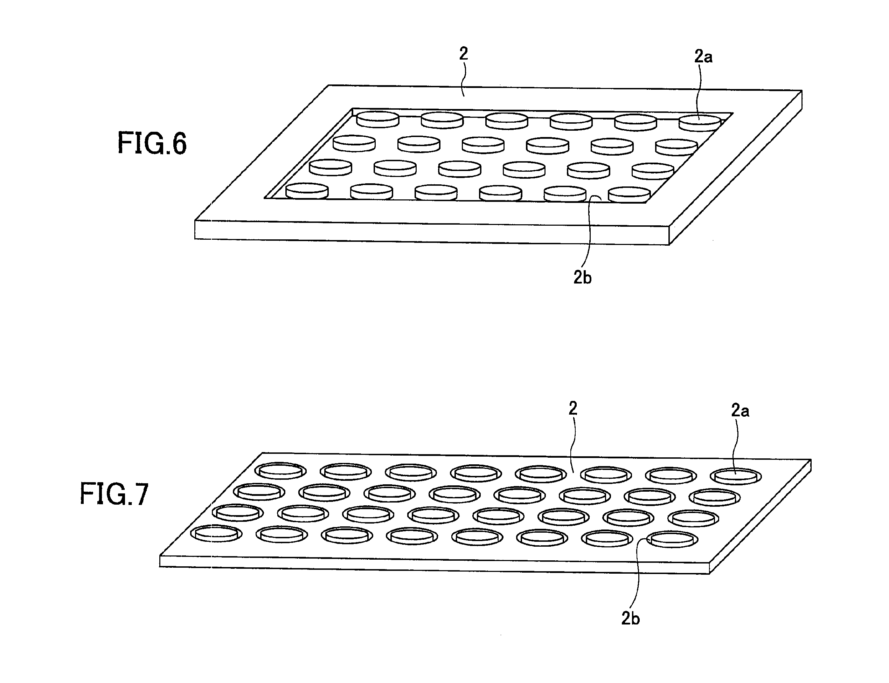

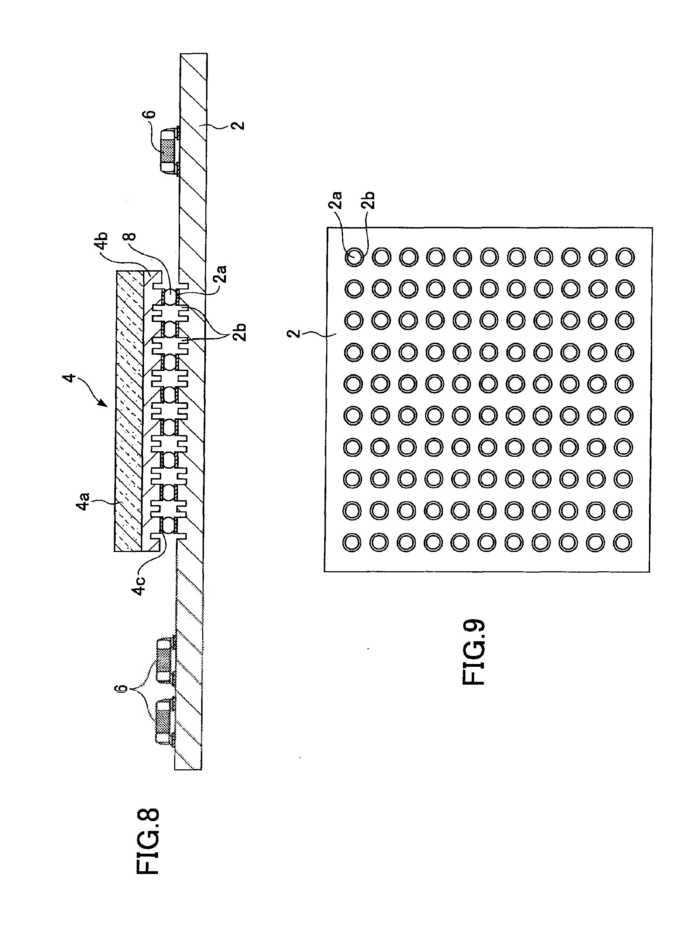

Preferably, as illustrated in FIG. 6, the shape of the electrode pads 2a formed on the circuit board 2 is circular so as to coincide with the shape of the corresponding solder bumps 8. In this case, as illustrated in FIG. 7, it is further preferable that annular grooves are formed so that the lower part of the corresponding electrode pads 2a of the circuit board 2 are separated from surrounding elements. FIG. 8 is a cross-sectional view of a circuit board assembly formed by mounting the semiconductor device 4 on the circuit board 2 having the annular grooves 2b as illustrated in FIG. 7. In this case, for example, the annular grooves 2b may be formed (provided) for all of the electrode pads 2a as illustrated in FIG. 9.

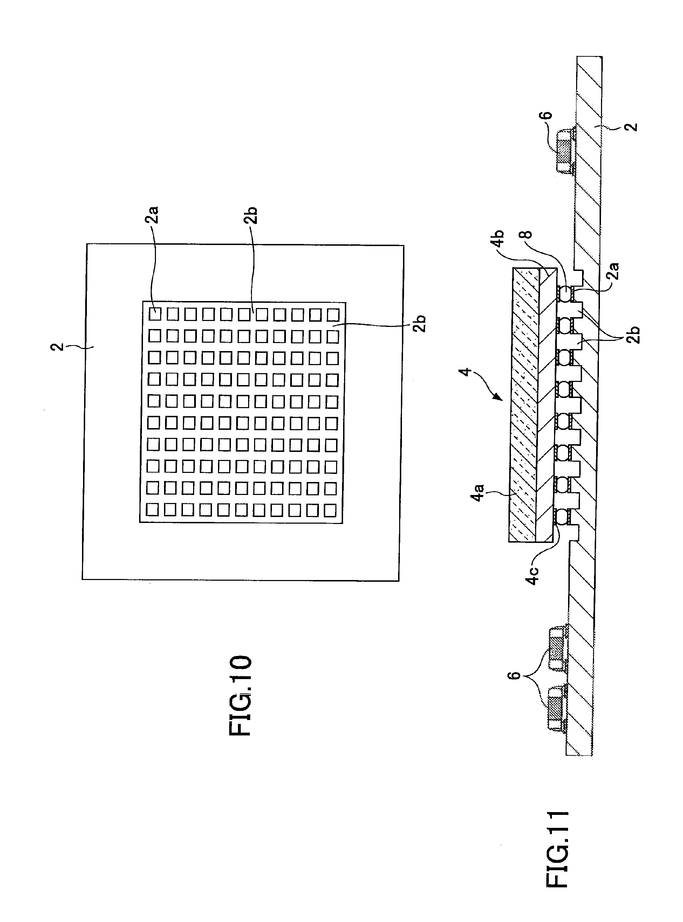

On the other hand, when the electrode pads 2a have a rectangular shape, it is preferable that the grooves 2b also have the rectangular shape so as to coincide with the rectangular shape of the electrode pads 2a. In this case, the grooves 2b may be formed in a (an orthogonal) lattice manner as illustrated in FIG. 10. FIG. 11 is a cross-sectional view of a circuit board assembly formed by mounting the semiconductor device 4 on the circuit board 2 having rectangular shaped grooves 2b as illustrated in FIG. 10.

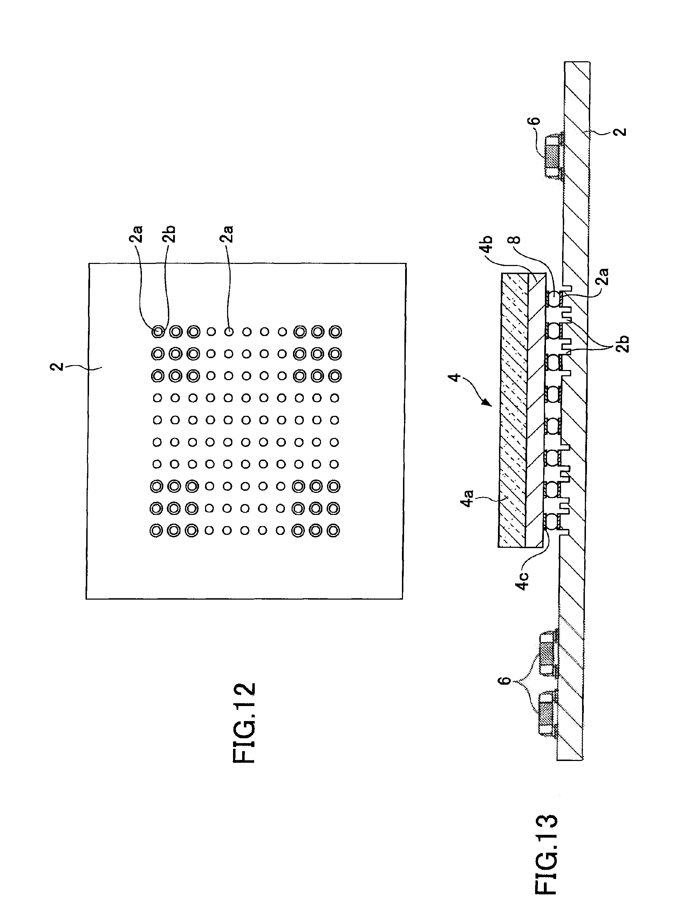

Among the plural solder bumps 8 arranged in a matrix manner, the solder bumps 8 on which the stress is likely to be concentrated are the solder bumps 8 disposed at the circumferential part of the circuit board 2, the circumferential part being more likely to be deformed. Namely, more stress is likely to be concentrated on the solder bumps 8 disposed at the circumferential part of the circuit board 2 because the circumferential part of the circuit board 2 is more likely to be deformed than any other part of the circuit board 2. Because of this feature, as illustrated in FIG. 12, the grooves 2b may be formed only around the electrode pads 2a to be bonded to the solder bumps 8 disposed near the four corners of the semiconductor device 4. In this case, as illustrated in FIG. 12, the electrode pads 2a are arranged in a matrix manner in a rectangular region on the surface of the circuit board 2, and the annular grooves 2b are formed only around the electrode pads 2a disposed near the four corners of the rectangular region where the electrode pads 2a are arranged. FIG. 13 is a cross-sectional view of a circuit board assembly formed by mounting the semiconductor device 4 on the circuit board 2 illustrated in FIG. 12.

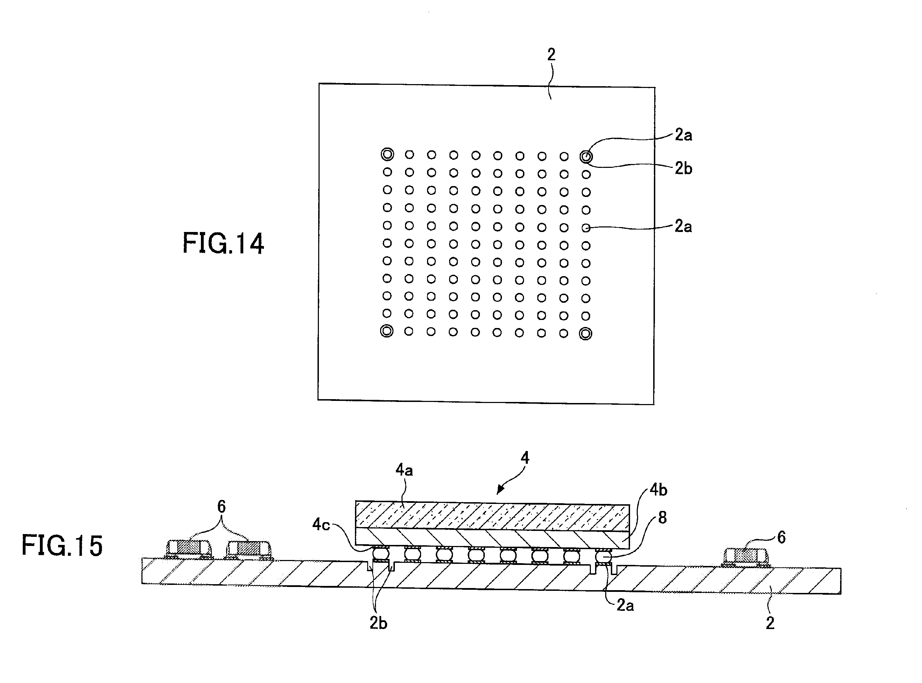

Further, among the solder bumps 8 arranged in a matrix manner, the solder bumps 8 where the maximum stress is more likely to be concentrated (generated) are four solder bumps 8 disposed at the respective four corners of the semiconductor device 4. Because of this feature, as illustrated in FIG. 14, the grooves 2b may be formed only around the electrode pads 2a to be bonded to the solder bumps 8 disposed at the four corners of the semiconductor device 4. As illustrated in FIG. 14, the electrode pads 2a are arranged in a matrix manner in a rectangular region on the surface of the circuit board 2, the annular grooves 2b are formed only around the four electrode pads 2a disposed at the respective four corners of the rectangular region where the electrode pads 2a are arranged in a matrix manner. FIG. 15 is a cross-sectional view of a circuit board assembly formed by mounting the semiconductor device 4 on the circuit board 2 illustrated in FIG. 14.

In the above embodiment, the grooves 2b formed on the circuit board 2 are described. However, the configurations described above may also be applied to the grooves 4d formed on the interposer substrate 4b of the semiconductor device 4.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present inventions have been described in detail, it should be understood that various changes, substitutions, and alterations could be made hereto without departing from the sprit and scope of the invention.

## Claims

1. A circuit board on which electronic parts are to be mounted, the circuit board comprising:
a substrate;
a plurality of electrode pads formed on the substrate; and
a groove formed between adjacent electrode pads on the substrate, wherein
the electrode pads are surrounded by the groove to have an air space between the adjacent electrode pads.

2. The circuit board according to claim 1, wherein
a planar shape of the electrode pads is rectangular,
the rectangular shaped electrode pads are arranged in a matrix manner, and
the groove is a straight grooves extending in a matrix manner between the electrode pads.

3. The circuit board according to claim 2, wherein
as a whole, the straight groove forms a concave part concave from the surface of the substrate and the electrode pads are formed on parts protruding from a bottom surface of the concave part.

4. The circuit board according to claim 1, wherein
a planar shape of the electrode pads is circular,
the circular shaped electrode pads are arranged in a matrix manner, and
the groove has an annular shape and surrounds the corresponding electrode pad.

5. The circuit board according to claim 4, wherein
the electrode pads are arranged in a matrix manner in a rectangular region, and
the groove having the annular shape is formed only around the electrode pads disposed near the four corners of the rectangular region.

6. The circuit board according to claim 4, wherein
the electrode pads are arranged in a matrix manner in a rectangular region, and
the groove having the annular shape is formed only around four electrode pads disposed at the respective four corners of the rectangular region.

7. A circuit board assembly comprising:
a circuit board according to any one of claims 1 through 6; and
a semiconductor device having external connection terminals, the semiconductor device being mounted by bonding between the electrode pads and the external connection terminals, wherein
an air space is formed in a region that is between the semiconductor device and the circuit board and that is other than the external connection terminals.

8. A circuit board assembly according to claim 7, wherein
the semiconductor device includes a semiconductor substrate and an interposer substrate, and
a groove is formed around corresponding electrode formed on a surface of the interposer substrate and the groove forms an air space by which lower parts of the electrodes on the interposer substrate are separated from surrounding elements.

9. A semiconductor device comprising:
a semiconductor substrate;
an interposer substrate formed on the semiconductor substrate;
a plurality of electrodes formed on the interposer substrate;
a groove formed around the electrodes on the interposer substrate, wherein
the groove forms an air space by which lower parts of the electrodes on the interposer substrate are separated from surrounding elements.
